Europäisches Patentamt

European Patent Office

Office européen des brevets

(19)

(11) Publication number: **0 267 766**
**A2**

# (12) EUROPEAN PATENT APPLICATION

(21) Application number: **87309885.9**

(22) Date of filing: **09.11.87**

(51) Int. Cl.⁴: **G 02 B 17/02**
**G 02 B 17/06**

(30) Priority: **10.11.86 GB 8626764**

(43) Date of publication of application:
**18.05.88 Bulletin 88/20**

(84) Designated Contracting States: **CH DE FR LI NL**

(71) Applicant: **Compact Spindle Bearing Corporation
17060 Knollview Drive P.O. Box 1109
Middletown California 95461 (US)**

(72) Inventor: **Phillips, Edward H. COMPACT SPINDLE
BEARING CORP.
P.O. Box 1109 17030 Knoll View Drive
Middletown§California 94561 (US)**

(74) Representative: **Milhench, Howard Leslie et al
R.G.C. Jenkins & Co. 26 Caxton Street
London SW1H 0RJ (GB)**

(54) **Catoptric reduction imaging systems.**

(57) Improved catoptric reduction imaging systems of a quassi-Cassegrainian type are presented wherein light from an object enters an imaging system through an aperture in one mirror of an imaging system and leaves the imaging system through an aperture in another mirror of the imaging system to form an image. In each imaging system, the sums of the inverses of the radii of the mirrors effecting each reflection are constrained to be substantially zero.

In a first improved catoptric reduction imaging system, two mirrors, one convex and one concave of equal base radii, are disposed axially, light from the object enters the imaging system through an aperture in the concave mirror, reflects from the convex mirror to the concave mirror and reflects from the concave mirror to form the image positioned beyond the convex mirror through an aperture in the convex mirror.

In a second improved catoptric reduction imaging system, two catoptric reduction imaging sub-systems (as described above) of different magnification are coupled back-to-back at their nominal image planes. In a refinement of this improved catoptric imaging system, each catoptric reduction imaging sub-system of such a coupled set of catoptric reduction imaging sub-systems is modified in a cross-coupled manner.

In a third improved catoptric reduction imaging system, a set of three mirrors are utilized to extend internal and output optical path lengths of the system via a pair of reflections from an intermediate mirror of the set of three mirrors.

In a fourth improved catoptric reduction imaging system, two mirrors are utilized wherein light reflects from first and second portions of the convex mirror to first and second portions of the concave mirror, respectively, and, finally, reflects from the second portion of the concave mirror to form the image positioned beyond the convex mirror through an aperture in the convex mirror.

In yet another catoptric reduction imaging system, two Cassegrainian imaging sub-systems of differing nominal object locations, one real and one imaginary, are coupled at a common object position. The object of the imaging system is positioned at the nominal image location of the imaging sub-system having the imaginary object location, and the image of the imaging system is positioned at the nominal image location of the imaging sub-system having the real object location.

*FIG. 1*

# Description

## Catoptric Reduction Imaging Systems

### Technical Field

This invention relates generally to the field of optics and more specifically, to catoptric, or all reflecting, imaging systems of the quasi-Cassegrainian type for providing finite magnification or its reverse (i.e. a scale reduction imaging system). The invention is directed toward providing an improved fully chromatically corrected and substantially diffraction limited reduction imaging system, for the microlithographic production of microcircuits, which features functional use at both non-actinic alignment wavelengths and far ultraviolet exposure wavelengths.

### Background Art

Typical of this general type of catoptric imaging system is a catoptric infinite conjugate telescope named a Cassegrainian telescope (after N. Cassegrain, a 17th century French physician, who invented it in 1672). The Cassegrainian telescope features a convex mirror located on axis inside the prime focus of a concave primary mirror, which mirror combination directs light rays through an aperture in the primary mirror to form an image that is positioned beyond the primary mirror. Aspheric surfaces are typically utilized for both the primary and secondary mirrors in order to minimize aberrations such as spherical, coma and astigmatism. However, when optimally corrected in such a manner, the infinite conjugate Cassegrainian telescope forms its image on a highly curved focal surface, the radius of which is about half that of the secondary mirror. Thus, the useful flat field of even a well corrected, infinite conjugate Cassagrainian telescope is severely limited.

Cassegrainian imaging systems with finite conjugates are known as well. Although such finite conjugate imaging systems can have slightly flatter fields than the infinite conjugate systems, they typically are even more limited in performance because their images generally have higher aberration content than the corresponding infinite conjugate imaging systems.

Aberration in any imaging system is determined by departure of wave fronts from an ideal spherical shape as they pass through the imaging system. The departure of the wave front from the ideal sphere is called the optical path difference (OPD). The OPD is related to the coordinates, $X_o, Y_o$, of a point in the exit-pupil aperture (the $Y_o$ coordinate lying in the meridian plane containing the image point and the imaging system axis) by five constants, $S_1, S_2, S_3, S_4$ and $S_5$, and the quantity $H_o$, according to the equation

$$OPD = S_1(X_o^2 + Y_o^2)^2 + S_2 Y_o(X_o^2 + Y_o^2)H_o + S_3(X_o^2 + 3Y_o^2)H_o^2 + S_4(X_o^2 + Y_o^2)H_o^2 + S_5 Y_o H_o^3$$

where the symbol $H_o$ refers to the height of the final image point above the imaging system axis. The maximum value of $H_o$, therefore, defines the field radius. Each of these five terms is considered to be a separate "aberration" wherein the coefficients $S_1$, $S_2, S_3, S_4$ and $S_5$ are referred to as Seidel sums. These aberrations are spherical, coma, astigmatism, Petzval field curvature (after the Hungarian mathematician J. Petzval who studied field curvature in the early 1840s), and distortion, respectively.

One possible method of correcting the deficiencies of a Cassegrainian imaging system would be to combine it with correcting refracting optics to flatten the image field and correct for the other aberrations. Such imaging systems are known as catadioptric reduction imaging systems. Non-diffraction limited catadioptric reduction imaging system designs have commonly been utilized for long focal length camera lenses. If an improved catadioptric reduction imaging system design of substantially diffraction limited performance could be provided, it would be useful for the photolithographic production of microcircuits.

As microcircuits contain structures of a literally microscopic size, it is generally convenient first to prepare a reticle which resembles the required design of a microcircuit but is larger in size. The reticle can then be used as the object of a reduction imaging system, and it is currently common practice to use a refracting reduction lens for this purpose.

The problem with the current refracting reduction lenses is that while they are substantially free of the five aberrations defined above, they are chromatically corrected for one wavelength only. This one chromatically corrected wavelength is usually so sharply defined that significant amounts of actinic light used to form an image arrive at that image out of focus. The catadioptric reduction imaging system design proposed above would substantially improve this deficiency. Owing to the fact that most of the imaging power of such a catadioptric reduction imaging system would be provided by its mirror surfaces, the resulting catadioptric imaging system's chromatic correction would be much broader than the present refracting systems.

In order to be useful for photolithographic production of microcircuits on semiconductive wafers in the future, an imaging system would have to be capable of printing features as small as 0.4 micrometers in photoresist coated semiconductive wafers. In addition, the imaging system's image world have to have an acceptable depth of field in order to accommodate the overall thickness of photoresist covering features already present on the semiconductive wafer (as processed in preceding levels of microcircuitry). This combination of requirements could be met by utilizing an imaging system such as the catadioptric reduction imaging system proposed above having acceptable numerical aperture (such as .3 n.a.), and using actinic wavelengths extending into the far ultraviolet end of the spectrum (such as 248nm).

At the same time, in order to facilitate alignment of the features already present on the semiconductive wafer (as processed in preceding levels of microcircuitry) with the image of the reticle formed by the proposed catadioptric imaging system, it would also be extremely useful for such an imaging system's chromatical correction to extend into the range of non-actinic wavelengths. The range of chromatic correction should include at least one commonly utilized non-actinic alignment wavelength such as 546nm (the "green" line of Hg).

In general, however, a substantially diffraction limited reduction imaging system, of the catadioptric type having broad chromatic correction extending from 546nm into the far ultraviolet wavelengths has not been demonstrated to date. Further, such an improved finite conjugate, catadioptric reduction imaging system design does not seem possible via the utilization of presently known optical materials.

One method of providing a highly corrected and planer image field for an astronomical all mirror telescope is shown in invited paper LO-108 entitled COMPARISON OF LARGE APERTURE TELESCOPES WITH PARABOLIC AND SPHERICAL PRIMARIES by Dietrich Korsch and published in Optical Engineering, Vol. 25, No. 9 by the Society of Photo-Optical Instrumentation Engineers (SPIE). This paper discloses a four aspheric mirror, quasi-Cassegrainian imaging system with one infinite conjugate. The performance of this imaging system is achieved by using a concave parabolic primary mirror, a convex secondary mirror, a concave tertiary mirror, and a convex quaternary mirror wherein an intermediate image is formed between the secondary and tertiary mirrors and the secondary, tertiary and quaternary mirrors are defined by sixth-order polynomials. The addition of the tertiary and quaternary mirrors makes it possible to further suppress the S1, S2, S3 and S5 Seidel sums defined hereinabove and achieve larger corrected field angles than is possible with a fully corrected two mirror Cassegrainian telescope. Configuring the imaging system with the intermediate image makes the flat field possible. This is because the secondary mirror is less convex in order to form the intermediate image within the axial distance to the primary mirror and the tertiary mirror is strongly concave in order to have the intermediate image beyond its prime focus and to therefore be able to form the final image in concert with the quaternary mirror. The combination of all the mirror radii is chosen to suppress the S4 Siedel sum and the resulting Petzval field curvature. For the four mirror imaging system, the S4 Siedel sum (or Petzval sum) becomes simply

$$S4 = 1/F1 + 1/F2 + 1/F3 + 1/F4$$

where $F1$, $F2$, $F3$ and $F4$ are the focal lengths of the four mirrors, respectively. Since $F1$ and $F3$ are positive focal lengths, $F2$ and $F4$ are negative focal lengths, and the radius of the secondary mirror (and therefore its focal length) is modified as described above, it is possible to achieve a substantially zero value for S4. In general, the suppression of S4 is a criteria for achieving flat image fields because the mirrors of the quasi-Cassegrainian imaging systems tend to be optically located nearer to aperture planes than field planes and it is not possible to achieve suitable field flattening via the use of aspheric correction of the mirror surfaces as with the S1, S2, S3 and S5 Siedel sums.

The geometric form of the astronomical all mirror telescope described above is not suitable for use as a catoptric reduction imaging system firstly because the secondary mirror would tend to obscure the field of view of the object by the primary mirror, and secondly because the quaternary mirror is placed within a central aperture of the secondary mirror and is of very small relative diametral size. This means that it would so severely vignette the marginal light rays forming the image that all of the light rays forming the image might be eliminated.

A four aspheric mirror catoptric reduction imaging system of 10:1 reduction was described by D.J. Nicholas in SPIE paper number 645 10 entitled MULTIPLE ASPHERIC SYSTEMS FOR THE LITHOGRAPHY OF VLSIC presented at the SPIE Technical Symposium South East on Optics and Opto-Electric Systems, 31 March - 4 April, 1986, Orlando, Florida. This imaging system had an overall optical track length of some 3.9 meters, two 90 degree folds, and occupied a plan view area of approximately .7 meters by 2 meters. Its image numerical aperture is .24 and its fully corrected field diameter is 10mm. The computation of its four aspheric mirror surface contours was performed by utilizing a technique, known as perturbed aspherics, developed by Dr. Nicholas and presented in detail by him in a paper entitled THE USE OF PERTURBED ASPHERICS IN MULTI-WAVELENGTH FOCUSING OPTICS published in Optical Acta, 1984, Vol. 31, No. 9, 1069-1078.

The 10:1 four aspheric mirror catoptric reduction imaging system described above utilizes its first two aspheric mirrors (which are both concave) to form a distorted intermediate image. This intermediate image is a precisely convoluted distortion of the final image (of the intermediate image) which is then formed by the remaining two aspheric mirrors, wherein the remaining mirrors are arranged as a Cassegrainian imaging system with finite (approximately 1:1) conjugates. The Petzval sum of the first two concave mirrors and the remaining two mirrors comprising the Cassegrainian imaging system is substantially zero as indicated above.

The geometric form of the 10:1 four mirror aspheric mirror catoptric reduction imaging system described above is not suitable for use in the photolithographic reproduction of microcircuits either, for the following reasons: The overall size of the optical circuit is too large. The folded configuration is suitable for laboratory alignment procedures only. And, the folds are difficult to accomodate without distorting the various input and output pupils of the system.

What is needed are all mirror configurations that are moderate in size and axially disposed. Such configurations must have substantially zero Petzval (S4) sums. They should be quasi-Cassegrainian in form, utilize perturbed aspheric optimized mirror surfaces, and feature significantly reduced marginal ray incidence angles for all mirrors (the marginal ray incidence angle on the concave parabolic primary mirror of the astronomical telescope described above is as much as 26.56 degrees). This will reduce the amount of aspheric correction required for the suppression of the remaining Siedel sums and might even reduce the number of aspheric mirror surfaces required for such correction to as few as two surfaces.

Accordingly, it is a principal object of this invention to provide an improved catoptric reduction imaging system wherein two mirrors, one convex and one concave of equal base radii, are disposed axially, and wherein light from the object enters the imaging system through an aperture in the concave mirror, reflects from the convex mirror to the concave mirror and reflects from the concave mirror to form the image positioned beyond the convex mirror through an aperture in the convex mirror.

Another object of this invention is to provide an improved catoptric reduction imaging system wherein two catoptric reduction imaging sub-systems (as described in the principal object) of different magnification are coupled back-to-back at their nominal image planes where the larger reduction imaging sub-system receives light from the object and the lessor reduction imaging sub-system forms the image of the imrpoved catoptric reduction imaging system at its nominal object plane.

Another object of this invention is to provide an improved catoptric reduction imaging system wherein each catoptric reduction imaging sub-system of a coupled set of unequal magnification catoptric reduction imaging sub-systems is modified in a cross-coupled manner to further optimize the performance of the resulting catoptric reduction imaging system.

Another object of this invention is to provide an improved catoptric reduction imaging system wherein three mirrors are utilized to extend the optical path lengths between the first mirror of the imaging system and the third mirror of the imaging system, and the third mirror of the imaging system and the image, via intermediate reflections of the second mirror of the system.

Another object of this invention is to provide an improved catoptric reduction imaging system wherein two mirrors, one convex and one concave of equal base radii, are disposed axially, and wherein light from the object enters the imaging system through an aperture in the concave mirror, reflects from a first portion of the convex mirror to a first portion of the concave mirror, reflects from the first portion of the concave mirror back to a second portion of the convex mirror, reflects from the second portion of the convex mirror back again to a second portion of the concave mirror and, finally, reflects from the second portion of the concave mirror to form the image positioned beyond the convex mirror through an aperture in the convex mirror.

Still another object of this invention is to provide yet another catoptric reduction imaging system of novel configuration wherein two Cassegrainian imaging sub-systems of differing nominal object locations, one real and one imaginary, are coupled at a common object position, wherein the object of the catoptric reduction imaging sytem is positioned at the nominal image location of the Cassegrainian imaging sub-system having the imaginary object location, and the image of the catoptric reduction imaging system is positioned at the nominal image location of the Cassegrainian imaging sub-system having the real object location.

These and other objects, which will become apparent from an inspection of the accompanying drawings and a reading of the associated description, are accomplished according to illustrated preferred embodiments of the present invention by providing improved catoptric reduction imaging systems of a quasi-Cassegrainian type wherein light from an object enters an imaging system through an aperture in one mirror of the imaging system and leaves the imaging system through an aperture in another mirror of the imaging system to form an image.

In a first improved catoptric reduction imaging system, two mirrors, one convex and one concave of equal base radii, are disposed axially, light from the object enters the imaging system through an aperture in the concave mirror, reflects from the convex mirror to the concave mirror and reflects from the concave mirror to form the image positioned beyond the convex mirror through an aperture in the convex mirror.

In a second improved catoptric reduction imaging system, two catoptric reduction imaging sub-systems (as described above) of different magnification are coupled back-to-back at their nominal image planes. In this catoptric reduction imaging system, the larger reduction imaging sub-system receives light from the object and the lessor reduction imaging sub-system forms the image of the improved catoptric reduction imaging system at its nominal object plane. In a refinement of this improved catoptric imaging system, each catoptric reduction imaging sub-system of such a coupled set of catoptric reduction imaging sub-systems is modified in a cross-coupled manner to further optimize the performance of the resulting catoptric reduction imaging system.

In a third improved catoptric reduction imaging system, three mirrors are utilized to extend the optical path lengths between the first mirror of the imaging system and the third mirror of the imaging sytem, and the third mirror of the imagig system and the image via intermediate reflections of the second mirror of the system. The second mirror of this improved catoptric reduction imaging system may be concave, flat or convex, but the resulting Petzval sum of the inverse of each of the four focal lengths associated with the four reflections (from the first mirror, the second mirror, the third mirror and the second mirror again) must be substantially zero.

In a fourth improved catoptric reduction imaging system, two mirrors, one convex and one concave of equal base radii, are disposed axially, light from the object enters the imaging system through an aperture in the concave mirror, reflects from a first portion of the convex mirror to a first portion of the concave mirror, reflects from the first portion of the concave mirror back to a second portion of the convex mirror, reflects from the second portion of the the convex mirror back again to a second portion of the concave mirror and, finally, reflects from the second portion of the concave mirror to form the image positioned beyond the convex mirror through an aperture in the convex mirror.

In yet another catoptric reduction imaging system, two Cassegrainian imaging sub-systems of differing nominal object locations, one real and one imaginary, are coupled at a common object position, wherein the object of the catoptric reduction imaging system is positioned at the nominal image location of the Cassegrainian imaging sub-system having the imaginary object location, and the image of the catoptric reduction imaging system is positioned at the nominal image location of the Cassegrainian imaging sub-system having the real object location.

Brief Description of the Drawings

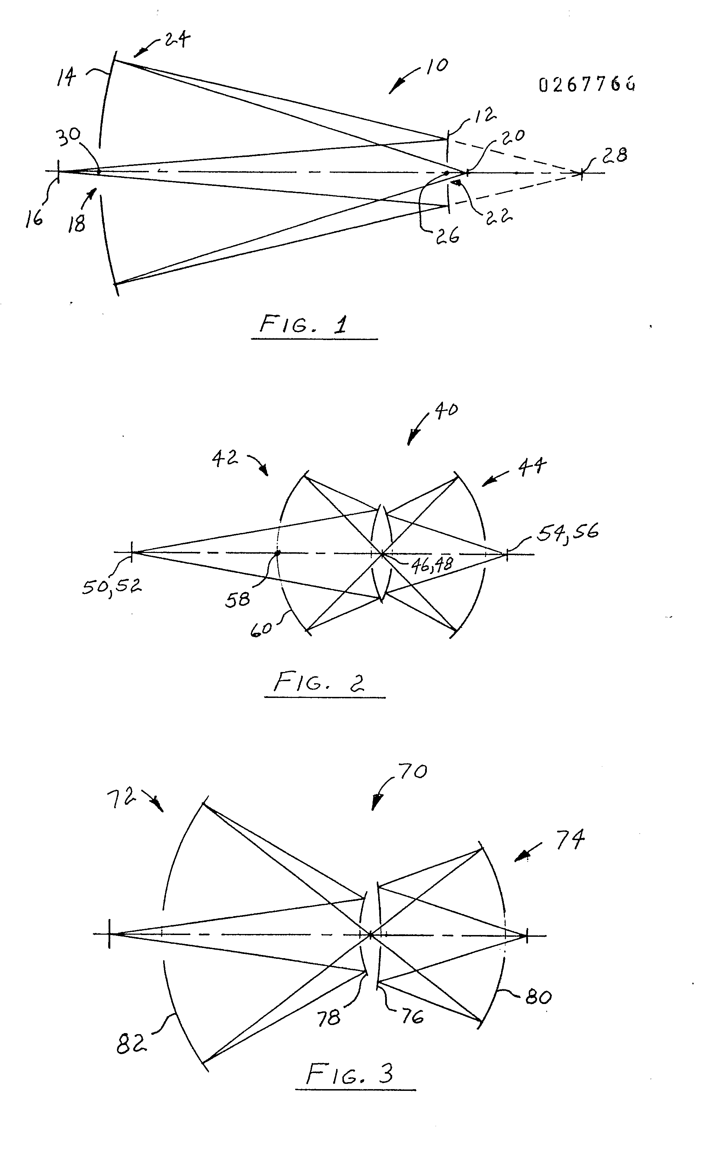

FIG. 1 is a sectional drawing showing an improved catoptric reduction imaging system having two mirrors of equal radii wherein two mirrors, one convex and one concave of equal base radii, are disposed axially, and wherein light from the object enters the imaging system through an aperture in the concave mirror, reflects from the convex mirror to the concave mirror and reflects from the concave mirror to form the image positioned beyond the convex mirror through an aperture in the convex mirror.

FIG. 2 is a sectional drawing showing an improved catoptric reduction imaging system having two catoptric reduction imaging sub-systems (as shown in FIG. 1) of different magnification coupled back-to-back at their nominal image planes where the larger reduction imaging sub-system receives light from the object and the lessor reduction imaging sub-system forms the image of the improved catoptric reduction imaging system at its nominal object plane.

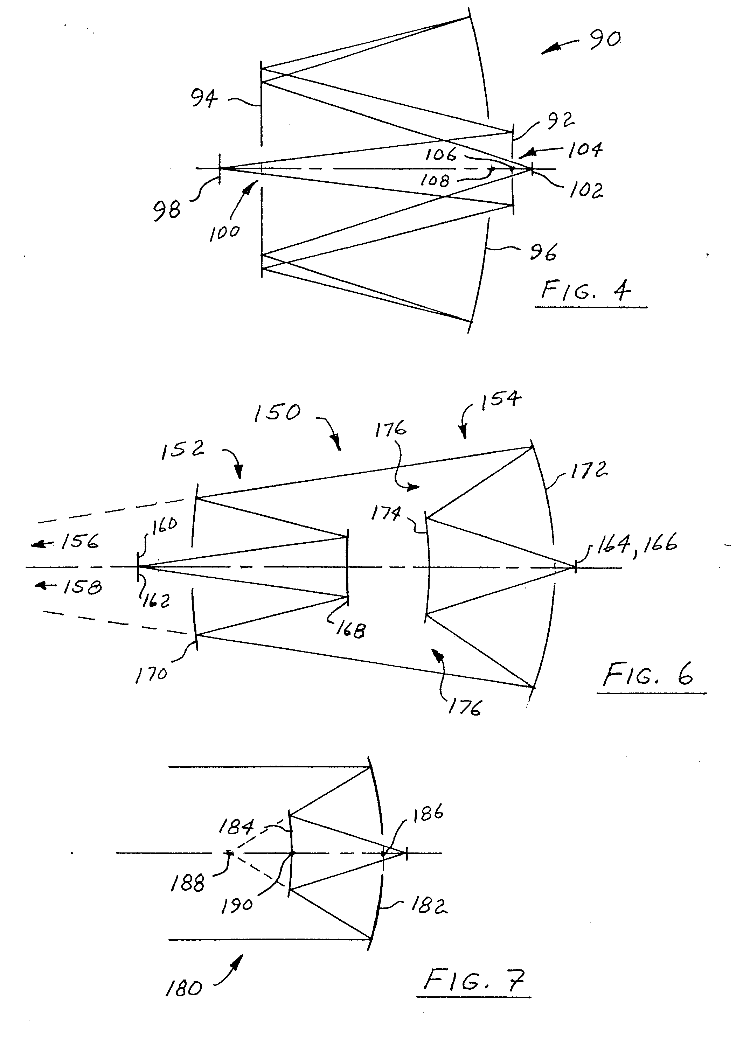

FIG. 3 is a sectional drawing showing an improved catoptric reduction imaging system having a coupled set of unequal magnification catoptric reduction imaging sub-systems modified in a cross-coupled manner to further optimize the performance of the resulting catoptric reduction imaging sytem.

FIG. 4 is a sectional drawing showing an improved catoptric reduction imaging system, and the third mirror of the imaging system having three mirrors which are utilized to extend the optical path lengths between the first mirror of the imaging system and the third mirror of the imaging system and the image via intermediate reflections of the second mirror of the system.

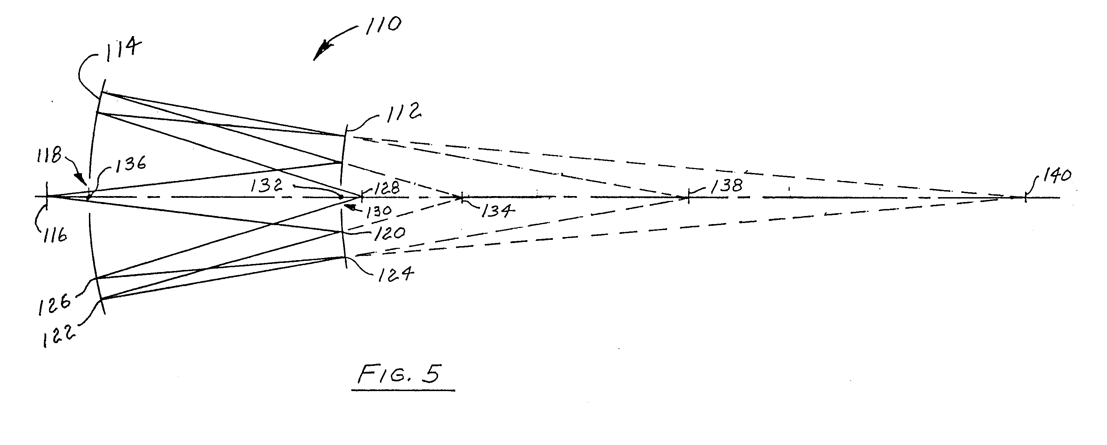

FIG. 5 is a sectional drawing showing an improved catoptric reduction imaging system having two mirrors, one convex and one concave of equal base radii, disposed axially, wherein light from the object enters the imaging system through an aperture in the concave mirror, reflects from a first portion of the convex mirror to a first portion of the concave mirror, reflects from the first portion of the concave mirror back to a second portion of the convex mirror, reflects from the second portion of the convex mirror back again to a second portion of the concave mirror and, finally, reflects from the second portion of the concave mirror to form the image positioned beyond the convex mirror through an aperture in the convex mirror.

FIG. 6 is a sectional drawing showing a catoptric reduction imaging system comprising two Cassegrainian imaging sub-systems of differing nominal object locations, one real and one imaginary, coupled at a common object position, wherein the object of the catoptric reduction imaging system is positioned at the nominal image location of the Cassegrainian imaging sub-system having the imaginary object location, and the image of the Cassegrainian reduction imaging system is positioned at the nominal image location of the Cassegrainian imaging sub-system having the real object location.

FIG. 7 is a sectional drawing showing the limited field-aperture sum of a Cassegrainian imaging sub-system whose nominal object location is at infinity.

Description of the Preferred Embodiments

Shown in FIG. 1 is an improved catoptric reduction imaging system 10, of reversed quasi-Cassegrainian form, having a convex mirror 12 and a concave mirror 14 wherein the mirrors 12 and 14 are of equal base radii and are disposed axially. Light from an object 16 enters the imaging system 10 through an aperture 18 in the concave mirror 14, reflects from the convex mirror 12 to the concave mirror 14 and reflects from the concave mirror 12 to form an image 20 located beyond the convex mirror 12 through an aperture 22 in the convex mirror 12. As can be seen in FIG. 1, imaging system 10 features a significantly reduced marginal ray incidence angle 24. This is because the light forming the image 20 passes through the aperture 22 in the convex mirror 12 rather than being forced to go around it as light coming from the object of a normal Cassegrainian imaging would have to do. The required base radius for the two mirrors can be found from the simultaneous solution of the equations

$$s = L + Lo$$
$$s' = sR/(2s + R) \ ,$$
$$s'' = s + s'\text{-}Lo \ ,$$
$$s''' = s''/(2s''\text{-}R) \text{ and}$$
$$s''' = L + Li \ ,$$

where s is the distance from the object 16 to the apex 26 of the curve determining the surface of the convex mirror 12, s′ is the distance from the apex 26 to the imaginary image 28 of the object 16 located behind the convex mirror 12, s″ is the distance from the imaginary image 28 to the apex 30 of the curve determining the surface of the concave mirror 14, s‴ is the distance from the apex 30 to the image 20, L is the distance from the apex 26 to the apex 30, Lo is the distance from the object 16 to the apex 30, and Li is the distance from the apex 26 to the image 20.

The imaging system 10 is fundamentally limited in its minimum reduction ratio,

$M = s(s'')/s'(s''')$,

as can be determined by evaluating the foregoing equations with $Lo = Li = 0$. For this case, $R = 2L/3$ and $M = 2+3$.

Specifications (with length values expressed in mm) for one practical system (with non-zero Lo and Li values) are as follows:

$L = 850$
$Lo = 100$
$Li = 50$
$s = 950$
$s' = 332$
$s'' = 1182$
$s''' = 900$
$R = 1022$
$M = 3.75$

The overall track length of the imaging system 10 is 1000mm. In addition, the image 20 of the imaging system 10 can have a useful field diameter of 25mm together with a numerical aperture of 0.3 and an obscuration value of 0.38, where the obscuration value is the ratio of the inside diameter of the useful aperture divided by the outside diameter of the aperture.

Shown in FIG. 2 is an improved catoptric reduction imaging system 40 having two catoptric reduction imaging sub-systems 42 and 44, as described above but constrained to have different magnification. They are coupled back-to-back at their nominal image planes 46 and 48, respectively. The larger magnification imaging sub-system 42 receives light from the object 50 at its nominal object plane 52 and the lessor magnification imaging sub-system 44 forms the image 54 of the imaging system 40 at its nominal object plane 56. The imaging sub-system 44 is geometrically similar to the imaging system 10 with a magnification value of approximately 3.8. The imaging sub-system 42, on the other hand, has a significantly longer path length from its nominal object plane 52 to the apex 58 of the curve defining its convex mirror 60. This results in its magnification value being as much as 6 or 7. Since the overall magnification of the imaging sytem 40 is the ratio of the magnification of the imaging sub-system 42 divided by the magnification of the imaging system 44, the overall magnification ratio of the imaging system 40 can be in the order of 2.

Specifications for one system are as follows:
For the imaging sub-system 42:
$L = 229$
$Lo = 356$
$Li = 25$
$s = 584$
$s' = 117$
$s'' = 346$
$s''' = 254$
$R = 293$
$M = 6.79$

For the imaging sub-system 44:
$L = 229$
$Lo = 51$
$Li = 25$
$s = 279$
$s' = 94$

$s'' = 323$
$s''' = 254$
$R = 284$
$M = 3.77$

The overall track length for the imaging system 40 is 914mm. The overall magnification is 1.80. Finally, the image 54 of the imaging system 40 can also have a useful field diameter of 25 mm together with a numerical aperture of 0.3 and an obscuration value of 0.38.

Shown in FIG. 3 is an improved catoptric reduction imaging system 70, having two catoptric reduction imaging sub-systems 72 and 74, similar to the imaging system 40. However, in the imaging system 70 each of the imaging sub-systems 72 and 74 has been modified in a cross-coupled manner to further optimize the performance of the resulting imaging system 70. The overall magnification of the imaging system 70 is increased by increasing the radius of convex mirror 76 of the imaging sub-system 74 and decreasing the radius of the convex mirror 78 of the imaging sub-system 72. In order to keep the Petzval sum substantially unchanged, the sum of the inverses of the two base radii has been kept at the same value. Concomitantly, in order to maintain the L and Lo values of the imaging sub-system 74 unchanged, the radius of concave mirror 80 of the imaging sub-system 74 has also been increased. Again concomitantly, the radius of concave mirror 82 of the imaging sub-system 72 has been decreased to a value sufficient to keep the sum of the inverses of the base radii of the concave mirrors 80 and 82 unchanged in order to keep the Petzval sum substantially unchanged (and therefore substantially equal to zero as before).

The primary advantage of making the changes outlined above is that the numerical aperture of the light rays forming the intermediate image is reduced. This allows a smaller aperture to be formed in the convex mirrors 76 and 78 with an associated increase in the aperture-field sum for the imaging system 70 as compared with the imaging system 40. Specifications for one system are as follows:
For the imaging sub-system 72:
$L = 482$
$Lo = 128$
$Li = 25$
$s = 610$
$s' = 121$
$s'' = 603$
$s''' = 507$
$Rcvx = 302$
$Rccv = 545$
$M = 5.99$

For the imaging sub-system 74:
$L = 305$
$Lo = 51$
$Li = 25$
$s = 356$
$s' = 207$
$s'' = 512$
$s''' = 330$
$Rcvx = 991$
$Rccv = 401$
$M = 2.66$

The overall track length for the imaging system 70 is 1016. The overall magnification is 2.25. The image 84 of the imaging system 70 can have a useful field diameter of 35mm together with numerical aperture of 0.3 and an obscuration value of 0.33. Finally, the Petzval sum is as follows:

$$S4 = 2(1/545 + 1/401 - 1/302 - 1/991) = 0.00$$

Shown in FIG. 4 is an improved catoptric reduction imaging system 90 having three mirrors. A first mirror 92 which in general is convex. A second mirror 94 which is shown as being flat but, in general, may be either convex, flat or concave. And, a third mirror 96 which in general is concave. Light from the object 98 enters the imaging system 90 through an aperture 100 in the mirror 94, reflects from the mirror 92 to the mirror 94, reflects from the mirror 94 to the mirror 96, reflects from the mirror 96 back to the mirror 94, and reflects from the mirror 94 to form the image 102 located beyond the mirror 92 through an aperture 104 in the mirror 92. As hereinbefore described, the sum of the inverse of the mirror reflections must be substantially zero, but since there are two reflections from the mirror 94 the calculation of the Petzval sum is as follows:

$$S4 = 2(1/Rm92 + 2/Rm94 + 1/Rm96) = 0.00 \ ,$$

where $1/Rm92$ is negative, $2/Rm94$ is negative if the mirror 94 is convex, $2/Rm94$ is zero if the mirror 94 is flat, $2/Rm94$ is positive if the mirror 94 is concave, and $1/Rm96$ is positive. The substantial effect of this configuration is that the effective path lengths for $s''$ and $s'''$ can be made significantly longer than even the overall track length for imaging system 90.

Specifications for a case wherein the mirror 94 is flat (as shown in FIG. 4), and the apexes 106 and 108 of the curves utilized to determine the surfaces of the mirrors 92 and 96, respectively, are axially displaced by a distance Ld, are as follows:

$$L = 610$$
$$Lo = 102$$
$$Ld = 51$$
$$Li = 51$$
$$s = 711$$
$$s' = 356$$
$$s'' = 1626$$
$$s''' = 1270$$
$$R = 1426$$
$$M = 2.56$$

The overall track length of the imaging system 90 is 762mm. The image 102 of the imaging system 90 can have a field diameter of 35mm together with a numerical aperture of 0.3 and an obscuration value of 0.38. This has been accomplished with a relatively short overall track length but at the penalty of a considerably larger mirror diameter fo the mirror 96.

Shown in FIG. 5 is an improved catoptric reduction imaging system 110 having a convex mirror 112 and a concave mirror 114 wherein the mirrors 112 and 114 are of equal base radii and are disposed axially. Light from the object 116 enters the imaging system 110 through an aperture 118 in the concave mirror 114, reflects from a first portion 120 of the convex mirror 112 to a first portion 122 of the concave mirror 114, reflects from the first portion 122 of the concave mirror 114 back to a second portion 124 of the convex mirror 112, reflects from the second portion 124 of the convex mirror 112 back again to a second portion 126 of the concave mirror 114 and, finally, reflects from the second portion 126 of the concave mirror 114 to form the image 128 positioned beyond the convex mirror 112 through an aperture 130 in the convex mirror 112.

the required base radius for the two mirrors 112 and 114 can be found from the simultaneous solution of the equations

$$s = L + Lo \ ,$$
$$s' = sR/(2s + R) \ ,$$
$$s'' = s' + L \ ,$$
$$s''' = s''/(2s'' - R) \ ,$$
$$s'''' = s''' - L \ ,$$
$$s''''' = s''''/(2s'''' - R) \ ,$$
$$s'''''' = s''''' + L \ ,$$
$$s''''''' = s''''''/(2s'''''' - R) \ \text{and}$$
$$s''''''' = L + Li \ ,$$

where s is the distance from the object 116 to the apex 132 of the curve determining the surface of the convex mirror 112, $s'$ is the distance from the apex 132 to the imaginary image 134 of the object 116 located behind the convex mirror 112, $s''$ is the distance from the imaginary image 134 to the apex 136 of the curve determining the surface of the concave mirror 114, $s'''$ is the distance from the apex 136 to the imaginary image 138 of the imaginary image 134 located further behind the convex mirror 112, $s''''$ is the distance from the imaginary image 138 to the apex 132, $s'''''$ is the distance from the apex 132 to the imaginary image 140 of the imaginary image 138, $s''''''$ is the distance from the imaginary image 140 to the apex 136, $s'''''''$ is the distance from the apex 136 to the image 128, L is the distance from the apex 132 to the apex 136, Lo is the distance from the object 116 to the apex 136, and Li is the distance from the apex 132 to the image 128.

The imaging system 110 is fundamentally limited in its minimum reduction ratio,

$$M = s(s'')s''''(s'''''')/s'(s''')s'''''( s''''''' ) \ ,$$

as can be determined by evaluating the foregoing equations with $Lo = Li = 0$. For this case, $R = 1.70L$ and $M = 1.96$.

Specifications for one system are as follows:

$$L = 610$$
$$Lo = 102$$
$$Li = 51$$
$$s = 711$$
$$s' = 307$$
$$s'' = 916$$
$$s''' = 1311$$
$$s'''' = 702$$
$$s''''' = 2334$$
$$s'''''' = 2943$$
$$s''''''' = 660$$
$$R = 1079$$
$$M = 2.64$$

The overall track length of the imaging system 110 is 762mm. The image 128 of the imaging system 110 can have a field diameter of 25mm together with a numerical aperture of 0.3 and obscuration value of 0.38.

Shown in FIG. 6 is a catoptric reduction imaging system 150 comprising two Cassegrainian imaging sub-systems, 152 and 154, of differing nominal object locations, 156 and 158, respectively. The nominal object locations, 156 and 158, comprise one (156) that is imaginary and one (158) that is real. The two Cassegrainian imaging sub-systems, 152 and 154, are coupled at a common object position comprising a superposition of imaginary object location 156 and real object location 158. The object 160 of the catoptric reduction imaging system 150 is positioned at the nominal image location 162 of the Cassegrainian imaging sub-system 152 and the image 164 of the catoptric reduction imaging system 150 is formed at the nominal image location 166 of the Cassegrainian imaging sub-system 154.

One method of making the Petzval sum of the catoptric reduction imaging system 150 substantially zero is to force the convex mirror 168 and concave mirror 170 of Cassegrainian imaging sub-system 152 to be of equal radius and the concave mirror 172 and convex mirror 174 of Cassegrainian imaging sub-system 154 to be of equal radius. Thus, the focal lengths of either of the mirrors of each set of mirrors 168 and 170, and 172 and 174, will be equal in magnitude but opposite in sign and therefore their inverses (and S4 value) will substantially sum to zero.

The resulting catoptric reduction imaging system, however, is of lessor interest than the various other catoptric reduction imaging systems described hereinbefore because of increased obscuration of the aperture 176 by the mirrors 168 and 174. This can be verified by analyzing the optical circuit of FIG. 7. Shown in FIG. 7 is a Cassegrainian imaging sub-system 180 with a concave mirror 182 and a convex mirror 184 of equal radii, R, whose nominal object position is located at infinity. The maximum possible field-aperture sum of the Cassegrainian imaging sub-system 180 would be obtained by setting its image position as close to the apex 186 of the curve determining the surface of the concave mirror 182 as possible and its aperture at the axial position of the concave mirror 182.

For instance, when the image is set at 1.25 times the distance, L, between the concave mirror 182 and the convex mirror 184, L can be found by the simultaneous solution of the equations

$s = R/2$ ,

$s' = s-L$ and

$s' = 1.25(L)R/(2(1.25)L+R)$ ,

where s is the distance between the prime focus 188 of the concave mirror 182 and the apex 186 and s' is the distance between the prime focus 188 and the apex 190 of the curve determining the surface of the convex mirror 184. The resulting values for L, s and s' are 0.290R , 0.500R and 0.210R , respectively.

When the aperture is set at the axial position of the concave mirror 182, the obscuration, Oa, for zero field diameter is equal to s'/s or 0.420. The location, Ao of the output pupil can be found by the simultaneous solution of the equations

$a' = -0.290R/(2(0.290)-1)$ ,

$a'' = (-a'+.290R)/(2(a'/R+0.290)+1)$ and

$Ao = a'' + 1.25(0.290)R$ ,

where a' is the location of the image (virtual) of the aperture behind the concave mirror and a'' is the location of the re-image (also virtual) of the aperture behind the convex mirror. The resulting value of a', a'' and Ao are 0.690R, 0.331R and 0.694R, respectively. The obscuration is a function of the ratio Rf/R, where Rf is the field radius, and the numerical aperture (n.a.) as can be found by the equation

$Oa = 0.420(1 + (a''/Ao)(Rf/R)/1.25(0.290)\tan\alpha)$ ,

where $\alpha$ is equal to the arcsine of the numerical aperture. If Rf/R = .04 and n.a. = .3 then Oa = 0.49. However, since the Cassegrainian imaging sub-system 154 has a real object positioned at the object location 158, the actual value of Oa for that Cassegrainian imaging sub-system is considerably larger as can be seen in FIG. 6. Thus, the catoptric reduction imaging system 150 is likely to have somewhat degraded optical performance.

As will be appreciated from the foregoing descriptions of exemplary embodiments, in its broadest aspect the present invention provides improved catoptric imaging systems of a quasi-Cassegrainian type wherein light from an object enters an imaging system through an aperture in one mirror of the imaging system and leaves the imaging system through an aperture in another mirror of the imaging system to form an image. In each imaging system, the sums of the inverses of the radii of the mirrors effecting each reflection are preferably constrained to be substantially zero.

In a first catoptric reduction imaging system described herein with reference to Fig. 1, two mirrors, one convex and one concave and both of generally the same base radius, are disposed axially, and light from the object enters the imaging system through an aperture in the concave mirror, reflects from the convex mirror to the concave mirror and reflects from the concave mirror to form the image positioned beyond the convex mirror through an aperture in the convex mirror.

In a second catoptric reduction imaging system described herein with reference to Fig. 2, two catoptric reduction imaging sub-systems of different magnification are coupled back-to-back at their nominal image planes. In a refinement of this sytem described with reference to Fig. 3, each catoptric reduction imaging sub-system of such a coupled set of catoptric reduction imaging sub-systems is modified in a cross-coupled manner.

In a third catoptric reduction imaging system described herein with reference to Fig. 4, a set of three mirrors is utilized to extend internal and output optical path lengths of the system via a pair of reflections from an intermediate mirror of the set of three mirrors.

In a fourth improved catoptric reduction imaging system described herein with reference to Fig. 5, two mirrors are utilized wherein light reflects multiply between portions of the convex mirror and portions of the concave mirror, and thereafter reflects from the concave mirror to form the image positioned beyond the convex mirror through an aperture in the convex mirror.

In yet another catoptric reduction imaging system as described herein with reference to Fig. 6, two Cassegrainian imaging sub-systems of differing nominal object locations, one real and one imaginary, are coupled at a common object position. The object of the imaging system is positioned at the nominal image location of the imaging sub-system having the imaginary object location, and the image of the imaging system is positioned at the nominal image location of the imaging sub-system having the real objection location.

While the invention has been described herein by reference to specific embodiments, it will be appreciated by those possessed of the relevant skill and knowledge that the invention in its widest aspects is susceptible of modification and variation beyond the systems specifically described, and the scope of the invention is accordingly not to be regarded as limited by the described embodiments.

It will also be appreciated that the invention extends beyond the optical systems described and extends also to the use of such optical systems in the microlithographic production of semiconductor microcircuits and to the inclusion of such optical systems in apparatus for microligthography.

## Claims

1. Catoptric reduction imaging apparatus for forming an image of an object; characterized by:
two mirrors, one convex and one concave of equal base radii, being disposed axially, wherein light from the object enters the imaging system through an aperture in the concave mirror, reflects from the convex mirror to the concave mirror and reflects from the concave mirror to form the image positioned beyond the convex mirror through an aperture in the convex mirror.

2. Imaging apparatus as in claim 1 further characterized by:
having two catoptric reduction imaging sub-apparatus of different magnification which are coupled back-to-back at their nominal image planes wherein the larger reduction imaging sub-apparatus receives light from the object at its nominal object plane, and the lessor reduction imaging sub-apparatus forms the image of the imaging apparatus at its nominal object plane.

3. Imaging apparatus as in claim 2 further characterized by:
each catoptric reduction imaging sub-apparatus being modified in a cross-coupled manner wherein the radius of the convex mirror of the lessor reduction imaging sub-apparatus is enlarged in magnitude and the radius of the convex mirror of the larger reduction imaging sub-apparatus is decreased in magnitude such that the sum of their inverses remains substantially constant.

4. Imaging apparatus as in claim 1 further characterized by:
having three mirrors which are utilized to extend the optical path lengths between the first mirror of the imaging system and the third mirror of the imaging system, and the third mirror of the imaging system and the image, via intermediate reflections of the second mirror of the system.

5. Imaging apparatus as in claim 1 further characterized by:
having light reflect from a first portion of the convex mirror to a first portion of the concave mirror, reflect from the first portion of the concave mirror back to a second portion of the convex mirror, reflect from the second portion of the convex mirror back again to a second portion of the concave mirror and, finally, reflect from the second portion of the concave mirror to form the image positioned beyond the convex mirror through the aperture in the convex mirror.

6. Catoptric reduction imaging apparatus for forming an image of an object; characterized by:
having two Cassegrainian imaging sub-apparatus of differing nominal object locations, one real and one imaginary, wherein the two Cassegrainian imaging sub-apparatus are coupled at a common object position, and further wherein the object of the catoptric reduction imaging apparatus is positioned at the nominal image location of the Cassegrainian imaging sub-apparatus having the imaginary object location and the image of the catoptric reduction imaging apparatus is positioned at the nominal image location of the Cassegrainian imaging sub-apparatus having the real object location.

7. Catoptric imaging apparatus substantially as herein described with reference to any of the accompanying drawings.

8. A method or apparatus for microlithography which utilizes an apparatus as claimed in any of the preceding claims.

0267766

FIG. 1

FIG. 2

FIG. 3

0267766

FIG. 4

FIG. 6

FIG. 7

*Fig. 5*

0267766